# FASCICULE DE BREVET EUROPEEN

(11) **EP 1 060 457 B1**
(45) Date de publication et mention de la délivrance du brevet: **10.07.2002**
(21) Numéro de dépôt: 98946509.1
(22) Date de dépôt: 23.09.1998
(51) Int. Cl.: G06K 19/077

(54) **DISPOSITIF ELECTRONIQUE A PUCE JETABLE ET PROCEDE DE FABRICATION**
ELEKTRONISCHE VORRICHTUNG MIT WEGWERFCHIP UND VERFAHREN ZU DEREN HERSTELLUNG
ELECTRONIC DEVICE WITH DISPOSABLE CHIP AND METHOD FOR MAKING SAME

(30) Priorité: 26.09.1997 FR 9712444; 14.11.1997 FR 9714582
(43) Date de publication de la demande: 20.12.2000
(73) Titulaire: GEMPLUS, 13881 Gémenos Cédex (FR)
(72) Inventeur: BLANC, René-Paul, F-83860 Nans les Pins (FR); DESOUTTER, Isabelle, F-13600 La Ciotat (FR); GARNIER, Pierre, F-83500 La Seyne sur Mer (FR); MARTIN, Philippe, F-21200 Beaune (FR)
(86) Numéro de dépôt international: FR9802051
(87) Numéro de publication internationale: WO9917252

(56) Documents cités:
- EP-A- 0 595 549
- EP-A- 0 952 542
- US-A- 5 528 222
- PATENT ABSTRACTS OF JAPAN vol. 010, no. 338 (P-516), 15 novembre 1986 & JP 61 139894 A (MATSUSHITA ELECTRIC IND CO LTD), 27 juin 1986

## Description

La présente invention concerne le domaine des dispositifs électroniques à puce comportant une interface de communication et leur procédé de fabrication. Elle concerne notamment des dispositifs à puce dont l'interface est à contact et/ou à antenne tels que carte à puce, micromodule étiquette. Elle vise tout particulièrement les dispositifs à antenne d'usage ponctuel ou jetables aptes à communiquer à des distances supérieures à 50 cm notamment sous des fréquences de quelques méga-Hertz à plusieurs giga-Hertz.

On connaît la demande intemationale WO 97/26621 qui décrit un module à puce et à antenne utilisable comme étiquette le cas échéant. Des cartes sont obtenues par l'insertion du module antenne dans une cavité d'un corps de carte et certaines étiquettes sont obtenues par un conditionnement du module antenne dans un support quelconque tel qu'un jeton par exemple.

Ces modules comportent un film support à interface, appelé communément circuit imprimé, sur lequel sont disposés au moins une interface sous forme d'antenne et/ou sous forme de plages de connexion, un microcircuit tel qu'une puce connectée à ladite interface et un matériau d'enrobage protégeant le microcircuit et ses connexions. L'antenne est réalisée sur une face du micromodule notamment au verso de celui-ci, tandis que l'autre face peut être éventuellement muni de plages de connexion.

Le film support à interface doit posséder des propriétés mécaniques minimales en raison notamment d'exigences des procédés de fabrication actuels. En particulier, il a une souplesse telle qu'il peut s'enrouler sur des bobines, mais également une rigidité ou dureté telle que l'on peut envisager son entraînement par des picots engrenant sur des perforations latérales. La rigidité du film support à interface est également telle qu'il est cassant en cas de pliage.

Les documents EP-A-0595549 et US-A-5528222 décrivent tous deux un dispositif électronique à puce comprenant un film support mince et flexible, une interface conductrice plane et un microcircuit disposés sur ledit film support.

Les films supports utilisés actuellement sont choisis parmi le verre époxy, le polyimide, le polyéthylène téréphtalate (PET). Ils ont des propriétés et caractéristiques typiques suivantes: une épaisseur comprise entre 75 µm et 125 µm, un allongement à la rupture inférieur à 75%, une tenue en température allant jusqu'à au moins 160 °C.

L'interface est quant à elle généralement en cuivre; elle présente une surface dure, les pistes sont en général fines (50 à 200 µm et ont une définition précise de l'ordre de quelques microns. L'interface subit en général un traitement de surface par exemple de type au Ni-Au qui la rend encore plus dure, plus apte au soudage, et la protège de l'oxydation.

Les dispositifs obtenus selon la demande ci-dessus ont l'inconvénient d'être trop onéreux pour l'usage envisagé dans l'invention. En outre, ils ont des applications limitées qui ne correspondent pas aux objectifs de l'invention énumérés ci-après.

L'état de la technique le plus proche de l'invention est EP-A-0 952 542 qui n'est état de la technique qu'au titre de l'article 54(3) CBE, c'est-à-dire opposable à l'invention qu'au titre de la nouveauté. Ce document décrit entre autres une couche de compensation.

L'objectif principal de l'invention est de concevoir un dispositif électronique à puce avec ou sans contact, actif ou passif, très économique et néanmoins très fiable compatible avec un procédé de réalisation comportant le moins d'étapes possible et utilisant le plus possible de techniques standards économiques, de manière à promouvoir son utilisation et le rendre jetable le cas échéant.

Un autre objectif est de concevoir un dispositif ci-dessus qui en outre est apte à communiquer de préférence au-delà de 50 cm (dispositif passif) et au-delà du mètre (dispositif actif).

Un autre objectif est concevoir et de réaliser économiquement un module antenne et/ou à contact qui soit facilement et directement imprimable notamment chez l'utilisateur.

Un autre objectif est de concevoir un dispositif ci-dessus qui soit utilisable en toute fiabilité dans de nombreuses conditions et sur de multiples supports.

Un autre objectif est concevoir et de réaliser économiquement des cartes ou tickets à puce avec ou sans contact.

Certains objectifs sont atteints en utilisant un film support à interface ayant des propriétés totalement distinctes et à contre-courant de celles exigées pour les films support à interface du domaine des cartes à puce présentées supra, mais également en adoptant un procédé de fabrication en rouleaux, puis en adaptant ce procédé notamment au niveau de la connexion de la puce pour prendre en compte les nouvelles propriétés du film. D'autres objectifs sont atteints par une configuration spécifique du dispositif décrite ci-après.

Ainsi donc, l'invention a pour objet un dispositif électronique à puce conforme à la revendication 1.

Selon une caractéristique préférentielle, le dispositif électronique à puce se distingue en ce que le film support à interface possède des propriétés telles qu'il est apte à être froissé ou plié sur lui même sans détérioration.

De bons résultats ont été obtenus avec un film support et une interface aptes à être froissés ou pliés ensemble selon un rayon de courbure inférieur à 2,5 mm et de préférence inférieur à 1 mm.

Cette définition correspond au choix d'un film support dont les propriétés sont intrinsèquement dégradées par rapport aux films support de l'état de l'art et/ou l'épaisseur réduite combinées à une interface dont les propriétés intrinsèques sont également dégradées par rapport aux interfaces de l'état de l'art et/ou l'épaisseur réduite. Les propriétés de chacun (film support et/ou interface (s) ) sont à considérer en combinaison. Elles peuvent être en particulier énormément dégradées pour les deux, ou celles de l'un très dégradées et celles de l'autre moins; l'épaisseur de chacun peut être également plus ou moins réduite selon le degré de dégradation des matériaux du film support et de l'interface.

Grâce à une telle association et combinaison, on dispose d'un dispositif à faible coût et fiable malgré des manipulations qu'on peut lui faire subir.

On précise que dans certains cas, la dégradation, par exemple au niveau de la rigidité, peut s'accompagner d'autres qualités pour le produit final, par exemple au niveau de l'élasticité, mais qui occasionnent des difficultés de fabrication. La dégradation doit s'entendre par rapport aux propriétés actuellement recherchées dans le domaine de la carte à puce.

Selon une caractéristique, le film support possède une épaisseur inférieure à 75 µm, les meilleurs résultats étant obtenus avec une épaisseur comprise entre 10 µm et 30 µm.

Avec une telle minceur du film support, l'invention apporte non seulement un gain de matière avec une incidence potentielle sur le prix et surtout un gain dans la finesse du dispositif final offrant ainsi de nouvelles possibilités d'application décrites infra.

Selon d'autres caractéristiques préférentielles de l'invention, le film support peut être de préférence en matière polymère ayant un allongement à la rupture supérieur à 80 %, et/ou de dureté shore inférieure à 80, et/ou une température de transition vitreuse Tg inférieure à 0°C, et/ou une température de fusion inférieure à 130°C.

De préférence, le film support est choisi parmi le polypropylène (PP), Polyéthylène (PE), polyéthylène téréphtalate (PET). Dans d'autres cas, il peut comprendre une matière fibreuse par exemple cellulosique ou textile.

Le métal de l'interface est de préférence brut sans traitement de surface visant à le durcir par exemple du type Ni-Au. Il possède de préférence une épaisseur inférieure à 50 µm. L'aluminium et ses alliages sont les matériaux préférés.

Les matériaux comme le PE, le PP ... sont avantageusement très économiques car produits sur des rouleaux de grandes longueur et largeur dans un domaine distinct de la carte à puce, celui de l'emballage. Les complexes PE /aluminium ou PP/ aluminium que l'invention propose d'utiliser de préférence comme base pour l'élaboration d'un film support à interface, sont également fortement répandus notamment dans le domaine de l'emballage alimentaire pour des opercules de yaourt, bouchons de champagne...)

Selon une autre caractéristique, le dispositif comporte le microcircuit disposé de préférence à l'extérieur des spires notamment dans un angle du film support. De préférence encore, on dispose le microcircuit directement sur le film support.

Le dispositif comporte également de préférence un élément d'interface dit «strap» sur l'autre face pour ramener au moins une extrémité de l'antenne (6) au voisinage de la puce.

Ainsi, on peut libérer la plus grande surface d'impression possible et avoir un dispositif très fin en vue d'applications décrites infra, la puce étant au contact du film support Le recours au 'strap' est une solution intéressante expliquée en détail infra.

Selon l'invention, le dispositif se distingue en ce qu'il comprend un film de compensation disposé sur un film support, ledit film de compensation comportant un évidement contenant ledit microcircuit, ses connexions.

L'évidement peut contenir un matériau d'enrobage du microcircuit et de ses connexions. Le matériau d'enrobage est de préférence coffré au moins en partie par les parois de l'évidement.

Le film de compensation peut être utilisé en relation avec tout autre film support existant de l'art antérieur mais il y a plus d'intérêt à l'utiliser en relation avec un film support à interface apte à être plié conformément à l'invention.

Le film de compensation possède outre les avantages dans la fabrication du dispositif exposés par la suite, celui de compenser la hauteur du microcircuit et de le protéger afin notamment de permettre une impression sur toute la surface du dispositif sans détériorer le microcircuit.

Il a pour fonction d'aplanir la surface du dispositif de manière à disposer d'un dispositif sans protubérance et à recevoir le cas échéant un autre film de décoration et/ou un adhésif au-dessus du microcircuit.

Il protège également le microcircuit d'une pression exercée sur lui lors de sa fixation sur un support quelconque par un adhésif disposé notamment sur le film de compensation.

Il permet également de compenser la faible tenue mécanique du film support à interface en particulier dans ses diverses utilisations.

Il peut être choisi parmi des matériaux les plus variés et adaptés à une utilisation quelconque, sans pour autant changer le procédé présenté infra.

La présente invention a également pour objet des tickets et des cartes à puce comportant le dispositif. De préférence, Ils comprennent un corps de carte ou de ticket constitué par ledit film de compensation. Cela signifie qu'ils comportent un évidement dans lequel est disposé le microcircuit, le film support et l'interface s'étendant hors de l'évidement sur la surface du film de compensation.

On obtient ainsi des cartes à puce et tickets économiques avec une protection du microcircuit le cas échéant.

Selon une variante de réalisation, l'évidement est une cavité non traversante ou fermée par un film additionnel.

La présente invention a également pour objet un procédé selon la revendication 24.

L'interface est de préférence réalisée selon la technique économique de la gravure de motifs imprimés ou lithographiés sur une ou des surfaces conductrices, préalablement solidarisées sur le film support.

Grâce au choix de tels film support et interface mais également au choix de la technique de réalisation de l'interface, on dispose d'un film support à interface à faible coût contribuant ainsi à baisser le prix global du dispositif.

Le procédé se distingue également en ce qu'il comporte une étape selon laquelle on fixe un film de compensation sur ledit film support à interface, ledit film de compensation ayant au moins un évidement correspondant à un emplacement de microcircuit.

Cette étape peut être utilisée en relation avec tout autre film support existant de l'art antérieur mais il est particulièrement intéressant de l'utiliser en relation avec un film support à interface apte à être plié conformément à l'invention.

Le film de compensation renforce le film support à interface qui ainsi risque d'être plus résistant mécaniquement pendant les étapes du procédé en particulier au cours de son déplacement par traction.

Il permet également l'enroulement du film support à plat entre chaque étape le cas échéant, ou pour la livraison chez le client. Il évite ainsi l'utilisation à perte d'un film à intercalaires couramment utilisé comme protecteur entre les différentes étapes de fabrication infra.

L'étape d'impression peut être réalisée sur les deux côtés du dispositif sans endommagement du microcircuit.

En cas d'enrobage du microcircuit et de ses connexions, l'évidement du film de compensation peut avoir une fonction de coffrage.

Le film de compensation peut servir le cas échéant à recevoir des perforations latérales pour picot d'entraînement et de positionnement et permettre un conditionnement en bobines utilisation des moyens d'entraînement actuels.

Le film de compensation permet d'assortir le dispositif de divers matériaux. Il peut être notamment à base de cellulose ou en tout matériau polymère, tissus ou tout autre matériau se présentant sous la forme de feuille.

Selon une autre caractéristique on effectue la connexion du microcircuit par soudure ultrasons de fils conducteurs. Plus particulièrement, on a recours à de la soudure par fil d'aluminium pour des plots ou interfaces en aluminium.

Le recours à cette technique de connexion est particulièrement avantageuse car fiable, courante et économique. Comme expliqué infra, cette manière de procéder posait des difficultés qui la contre-indiquait pour une utilisation sur un film support à interface ayant des propriétés conformes à l'invention.

Selon une autre caractéristique, on utilise un film support à interface muni d'éléments d'interface sur ses deux faces. En particulier, on peut réaliser une armature de condensateur de chaque côté et/ou des 'straps' en même temps que l'interface.

Ainsi on peut baisser le coût de la réalisation de ces éléments d'interface puisqu'ils peuvent être réalisés en même temps avec la même technologie indiquée précédemment. Une alternative moins économique aurait consisté à réaliser une liaison par pont au-dessus des spires par une opération spécifique ou à l'ajout d'un condensateur discret.

Selon une autre caractéristique, les éléments d'interface de chaque côté du film support peuvent être connectés au travers du film support par des déchirements mécaniques et contacts mécaniques. Le cas échéant, on peut fixer ces liaisons par ultrasons.

Le choix de la finesse du film support à interface et le choix des matériaux conforme à l'invention rend possible le recours à un tel procédé de connexion. Il est particulièrement avantageux et économique car effectué sans apport de matière et peut se faire en une étape qui peut être masquée dans le procédé de fabrication du dispositif.

D'autres caractéristiques et avantages de l'invention apparaîtront à la lecture de la description ci-après faite en référence aux dessins annexés, donnés uniquement à titre d'exemple sur lesquels:
- la figure 1 représente une étiquette simplifiée présentant certaines des caractéristiques de l'invention identifiable à distance par signaux radiofréquence;
- la figure 2 représente une vue en coupe de l'étiquette de la figure 1 au niveau du micromodule;
- la figure 3 représente une variante de la figure 2;
- la figure 4 représente une variante de la figure 1;
- la figure 5 représente le verso de l'étiquette de la figure 4;
- la figure 6 représente une vue de la face supérieure d'une étiquette à plages de connexion;
- la figure 7, représente une structure de carte présentant certaines des caractérisqtiques de l'invention.
- la figure 8 représente une structure de carte selon l'invention vue en coupe;
- la figure 9 représente une autre structure du dispositif de l'invention conforme à l'invention.
- la figure 10 représente une vue d'ensemble de l'exécution du procédé de l'invention;
- la figure 11 représente une vue d'ensemble d'une variante d'exécution du procédé de l'invention pour la fabrication de cartes à puce et à antenne.
- la figure 11A représente une structure de carte obtenue selon le procédé illustré à la figure précédente;
- la figure 12 représente un test de pliage.

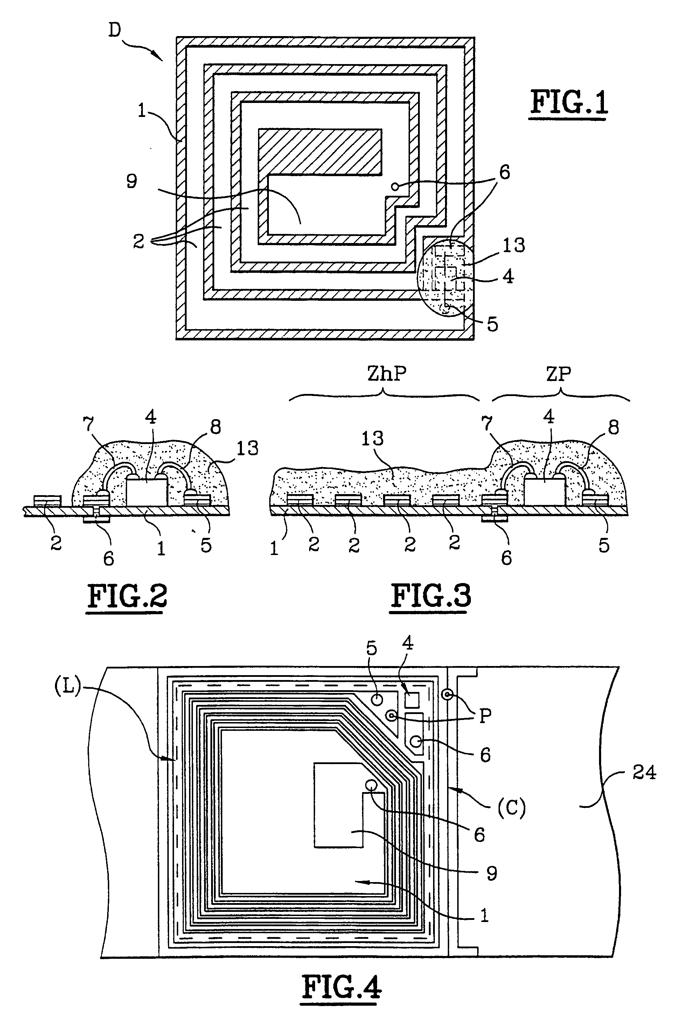

A la figure 1, un exemple de réalisation simplifié d'un dispositif électronique à puce présentant certaine des caractéristiques de l'invention se présente sous forme d'une étiquette électronique à puce et à antenne (self et condensateur). Il comprend un film support 1, une interface conductrice plane constitué dans cet exemple par des spires 2 d'une antenne plane 3 disposée en spirale sur ledit film support à partir de la bordure ce demier vers l'intérieur, et un microcircuit 4 tel une puce de circuit intégré connecté à ladite interface. L'antenne comporte deux extrémités respectivement interne et externe terminées ou formant chacune des plots de contact 5, 6. La connexion est dans cet exemple réalisée par des fils de liaison 7, 8.

Le dispositif comporte également un condensateur d'adaptation réalisé dans cet exemple par des surfaces conductrices 9, 10 disposées en regard de chaque côté du film support. Le cas échéant, le condensateur peut comporter des traces d'ajustage telles que des perforations ou autre élimination de portion de surface que l'on peut effectuer notamment par laser. Dans d'autres cas, un condensateur discret peut être rapporté sur le film ou être intégré dans le microcircuit.

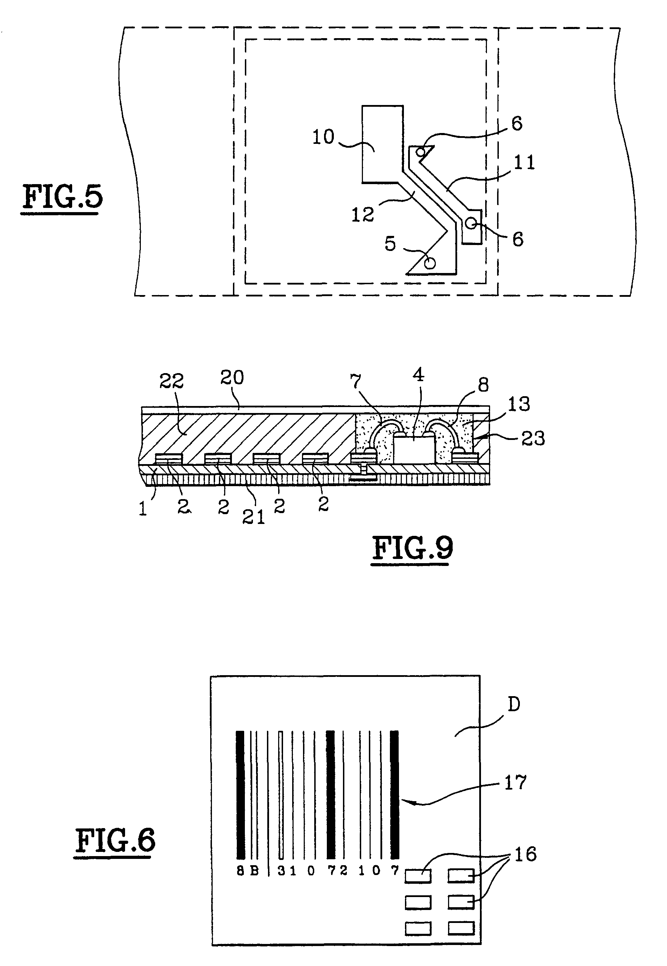

On a recours également à des éléments de circuits 11, 12 (straps) disposés au verso du film support (figure 5) pour rapprocher le contact 6 d'une extrémité de l'antenne ou de l'armature de condensateur, situé à l'intérieur des spires, à l'autre extrémité 5 située à l'extérieur des spires ou vice versa. En fait, le 'strap' 11 permet de ramener au moins une extrémité de l'antenne à proximité de l'emplacement de la puce situé dans ce cas à l'extérieur de l'antenne en bordure de l'étiquette. Dans le cas d'un film de compensation décrit infra, la position de la puce importe moins. Elle peut être notamment à l'intérieur des spires.

Selon une caractéristique de l'invention, une matière d'enrobage 13 recouvre au moins le microcircuit et/ou les fils de connexion de manière à les protéger au moins mécaniquement. Dans l'exemple, (figures 1, 2) la matière recouvre uniquement une zone d'emplacement du microcircuit (zp), connexions comprises, laissant le reste du dispositif dénudé.

Dans cet exemple, la zone de microcircuit occupe une surface équivalente à environ 4 mm x 5 mm, tandis que l'étiquette a une surface totale de 40 mm x 40 mm.

De préférence, le film support à interface possède des propriétés telles qu'il est apte à être froissé ou plié sur lui même sans détérioration.

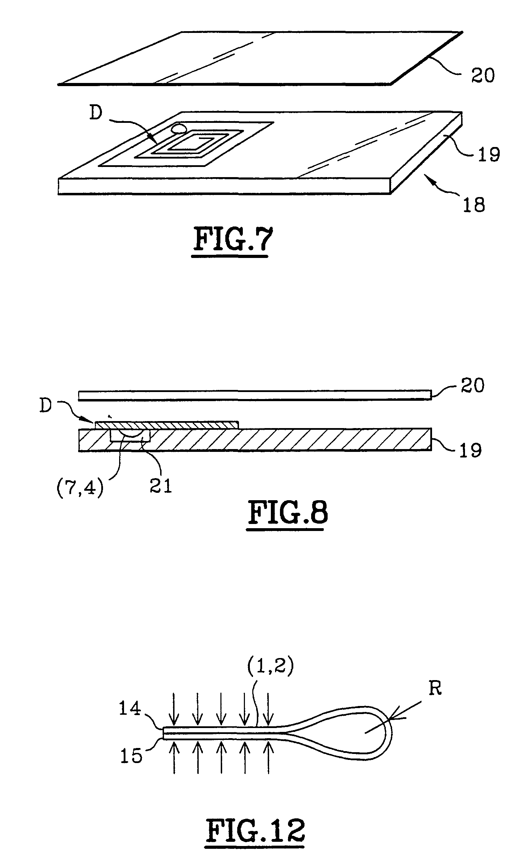

La figure 12 illustre un test de pliage destiné à caractériser un mode de réalisation préféré de l'invention. Selon ce test le film support à interface doit pouvoir se plier en dehors de la zone puce par exemple en deux ou en quatre, les bords opposés 14, 15 se touchant à plat pour former une pliure avec un faible rayon de courbure R. Dans d'autres cas, on doit pouvoir le chiffonner ou le froisser avec des pliures aléatoires ayant au minimum le rayon précité.

Par détérioration, on entend bien sûr une cassure ou rupture du film support le rendant impropre à supporter les spires. On entend encore une perte importante de la capacité à se déformer ensuite telle une déformation plastique qui conduit à la rupture après renouvellement de quelques pliages. L'interface est quant à elle détériorée lorsqu'elle perd ses propriétés de conduction électrique, notamment par diminution de section, ou rupture ou par perte importante d'élasticité qui la conduit à la rupture après quelques pliages (par exemple une dizaine).

On obtient des produits préférés lorsqu'ils supportent des pliages à un rayon de courbure R inférieur à 1 mm et notamment à 0,2 mm.

Pour atteindre ces performances, on utilise un film support en un matériau ayant un allongement à la rupture supérieur à 80 %, et/ou de dureté Shore inférieure à 80, et/ou un Tg inférieur à zéro degré Celsius, et/ou une température de fusion inférieure à 130 °C, associé à une épaisseur inférieure à 75 µm.

Les meilleurs résultats sont obtenus avec une épaisseur de film support comprise entre 10 µm et 30 µm.

Les films support dans l'exemple sont avantageusement des films aux propriétés très dégradées (déclassées, moins performants) comme le PP, le PE, voire moins dégradées comme le PET), par rapport à ceux couramment utilisés dans les modules cartes et antenne, tels les verres époxy ou les polyimides.

Conformément à un mode de réalisation préféré de l'invention, l'interface doit également avoir des dimensions appropriées et/ou des propriétés mécaniques notamment de ductilité/élasticité/dureté compatibles avec celles du film support pour satisfaire le test de pliage.

Dans l'exemple, l'interface est en d'aluminium sans traitement de surface notamment en nickel /or etc. Son épaisseur est inférieure ou égale à 50 µm et de préférence comprise entre 7 et 30 µm.

Le cas échéant, selon une alternative, le film support peut comprendre une matière fibreuse notamment cellulosique ou textile. Il peut être par exemple simplement en papier de très faible épaisseur comme ci-dessus. Des matières fibreuses textiles ont la propriété de se froisser sans rompre et de se défroisser de manière réversible.

A la figure 3, on utilise une épaisseur de couche de matériau de protection 13 la plus fine possible qui couvre toute la surface de l'étiquette. L'épaisseur obtenue de la zone de la puce (zp ) peut être inférieure à 400 µm et notamment inférieure à 300 µm pour une puce ayant une épaisseur de l'ordre de 150 µm. L'épaisseur obtenue de la zone hors puce (zhp) est inférieure à 150 µm, et notamment inférieure à 100 µm.

Dans le cas de la figure 3, on préfère utiliser un matériau de protection qui conserve une certaine élasticité et souplesse pour satisfaire le critère précédemment défini. Certaines résines époxy et acrylates peuvent convenir.

Dans l'exemple de la figure 2, des essais effectués avec au moins une centaine de pliages répétitifs à un rayon de courbure égal à 0,5 mm ont été concluants avec une étiquette sans enrobage sur l'antenne. Dans l'exemple de la figure 3, d'autres essais de pliage à un rayon de 2 mm n'ont pas affecté le fonctionnement des étiquettes ci-dessus.

De telles manipulations sont impossibles et/ou non conseillées avec les dispositifs à puce et interface de l'art antérieur.

L'étiquette a l'avantage de pouvoir être incorporée dans des produits très fins et/ ou très souples et passer inaperçu à l'oeil et au toucher tant ses caractéristiques mécaniques peuvent être proches ou inférieures à celles du produit. Le produit obtenu peut avoir notamment le toucher d'une pellicule voire d'une feuille de cigarette. Un tel dispositif peut trouver des applications en tant que dispositif électronique discret insérable ou superposable notamment à des produits fins tel que doublure de vêtement textile, cuir, produits en feuilles, en films en nappes, produits et emballages cartonnés, mais aussi et d'abord faire office d'étiquette à part entière. Le dispositif de l'invention sous forme d'étiquette peut également faire partie du film constituant le produit ou l'emballage, l'antenne étant par exemple réalisée sur un tissus, ou un film d'emballage lui même.

Dans la mesure ou le support peut être fin lui même et subir des pliages répétitifs, le dispositif est capable de suivre les déformations résultantes sans détérioration. Il assure de ce fait une fonction d'identification avec plus de fiabilité que les dispositifs de l'art antérieur dans de telles conditions d'utilisation.

A la figure 4, l'interface est réalisée sur une bande continue 24 de film support 1. Le microcircuit est disposé avantageusement dans un angle du film support et directement dessus. On choisit de préférence de positionner la puce dans l'angle de l'étiquette pour réduire les contraintes mécaniques liées à la manipulation, mais également pour avoir une surface disponible à l'impression la plus grande possible.

La bande 24 comprend un cadre conducteur (C) continu autour de l'interface et des points de mire (p) destinés au repérage et à l'indexation / positionnement de l'interface au cours des différentes opérations du procédé décrit infra. Le cadre conducteur permet de rigidifier la bande du film support et de réduire les coûts et temps de gravure le cas échéant. Des lignes fictives reportées en pointillés sur la bande illustrent des lignes de découpe délimitant le dispositif.

Les dessins de l'antenne sont conçus en fonction de la fréquence de fonctionnement choisie et pour optimiser de la portée (cas sans contact )

Dans l'exemple, l'antenne 2 est dessinée sur le film support de manière à pouvoir communiquer à une distance supérieure à 8 cm et de préférence supérieure à 50 cm (cas passif c'est-à-dire sans pile) et supérieur à 1 à 2 m (cas actif c'est-à-dire avec pile). La taille des spires est choisie maximale et leur nombre optimisé pour atteindre les distances escomptées, (en général, 4 à 6 tours sont nécessaires à des fréquences de 13 Mhz environ).

L'espacement entre les spires dépend du procédé de réalisation de l'antenne. Dans l'exemple, le pas des spires est de 1 mm, à comparer aux dispositifs actuels où on atteint plutôt des pas de 0,05 mm à 0,4 mm.

Pour joindre les extrémités de l'antenne au microcircuit, l'invention a recours de préférence à une construction avec "strap" comme visible sur la figure 5.

Selon une autre variante non représentée, le dispositif comporte avantageusement un condensateur, non pas sous forme d'armatures de chaque côté du film, mais intégré dans la puce. Cela permet de s'affranchir des variations de valeur du condensateur liées notamment aux variations d'épaisseur du film et de s'affranchir d'étapes d'ajustage d'antenne souvent fastidieuses. Cela est également préférable lorsque le film support n'est pas un bon diélectrique.

Selon une caractéristique non représentée visant à simplifier le dispositif, le film support comporte des d'éléments d'interface sur un seul côté, le condensateur pouvant être rapporté au-dessus du film support, ou mieux encore être dans la puce comme précédemment.

Pour éviter d'avoir des fils de connexion de grande longueur dans le cas où l'antenne comporte plus d'une spire et un pas relativement grand, on peut concevoir les spires de manière qu'elles aient une largeur plus fine qu'ailleurs localement, uniquement au niveau du microcircuit et des ses connexions..

De préférence encore, pour diminuer la longueur des fils de connexion tout en conservant une épaisseur minimale du dispositif, on peut disposer le microcircuit directement sur le film support et entre les spires qui le contoume. Le cumul des caractéristiques de cette variante ci-dessus permet encore de diminuer les coûts

Le microcircuit peut également être disposé sur les spires mais au détriment de la hauteur du dispositif et d'une bonne assise du microcircuit.

Dans d'autres cas, on peut disposer le microcircuit sur une plage d'interface de manière à accroître la stabilité et un meilleur accrochage par colle adhésive.

A la figure 6, on voit que l'interface du dispositif D comprend au moins des plages de connexion 16 sur la face visible sur le dessin. Le microcircuit est disposé sur l'autre face, des perforations à travers le film permettant d'accéder de manière connue aux plages de connexion. Le cas échéant, la puce peut être incorporée dans l'évidement d'un film de compensation décrit infra.

Il comporte également en exemple des impressions telles que des codes barres 17, disposées sur sa plus grande partie, les connexions et la puce étant dans en bordure du film support.

En variante, l'interface peut comporter à la fois des contacts et une antenne (non représenté). L'antenne peut être par exemple être disposée sur l'autre face non visible sur le dessin, le condensateur dans la puce.

A la figure 7, on voit une carte à puce 18 hors des normes ISO en vigueur. Elle comprend le dispositif (D) avec le film support 2, disposé sur un corps de carte support 19 qui peut être de dimension égale ou plus grande que le film, par exemple égale à au moins deux fois celle du film support 2. La face du dispositif ne portant pas la puce est de préférence mise au contact avec le corps de carte 19. Le microcircuit est orienté vers le haut à l'opposé du corps de carte 19.

La carte peut également comporter une deuxième feuille 20 disposée au-dessus du film support et peut être de même dimension que la carte 19 ou couvrir seulement le dispositif.

Selon un mode de réalisation de l'invention (figure 8), la carte 19 constitue un film de compensation. Il comprend un évidement 21 fermé dans lequel est inséré le microcircuit enrobé 4, le film support à l'interface (1, 2) s'étendant hors de la cavité sur la surface du corps de carte. L'extension du dispositif hors de la cavité n'est nullement gênant au toucher et visuellement du fait de la faible épaisseur du film support à interface. On obtient ainsi une carte qui est sensiblement plane, avec en plus un microcircuit protégé par la cavité.

Conformément à d'autres caractéristiques, le dispositif peut comprendre en outre un circuit résonant miniature annexe comportant une antenne de secours et/ou un condensateur intégré disposés dans le microcircuit de manière à compenser une défaillance de l'antenne ou du condensateur disposés sur le film support à interface. Il sera ainsi possible de récupérer des informations stockées dans la puce à l'aide d'un lecteur spécifique de proximité sans contact, ce qui confère plus de fiabilité au dispositif.

A cette fin, le microcircuit est apte à être alimenté et à communiquer à proximité via l'antenne de secours en cas de défaillance du circuit antenne du film support.

A la figure 9, on voit que le dispositif comprend un film de compensation 22 disposé sur un film support à interface. Le film de compensation peut être disposé sur toutes sortes de film support à interface comme connu de l'art antérieur mais il trouve plus de justifications et d'intérêts (exposés supra) avec ceux qui sont aptes à être pliés ou froissés conformément au test de pliage ci-avant.

Le film de compensation comporte un évidement 23 dans lequel se trouvent le microcircuit 4, ses connexions 7, 8 et le matériau d'enrobage 13. La paroi de l'évidement est en contact avec le matériau d'enrobage dans la mesure où elle forme un coffrage au moins en partie pour le matériau. Son épaisseur est de préférence telle que l'évidement 23 dépasse juste le microcircuit et son enrobage.

Le film de compensation peut être en une matière quelconque, souple de préférence pour les applications visées. Dans l'exemple, on a utilisé un matériau polymère PE d'épaisseur égale à 200 µm, pour une puce à 150 µm et des connexions avec des fils. On a montré qu'il était possible d'utiliser un film compensateur de moins de 50 µm pour une puce à 50µm et une connexion de type Flip chip ou par dépôt de colle conductrice de type "silver-glue" (demandes de brevet FR-A-2 761 697 ou FR-A-2 761 698). Ce qui permet dans ce cas d'obtenir un dispositif à puce de 110 µm max. La couche 22 est elle même imprimable.

Le dispositif peut comporter en outre au moins une couche de protection/personnalisation 20 et/ou couche adhésive 21 sur au moins une des faces du film support ou du film de compensation.

L'étiquette ainsi réalisée peut comporter toutes les fonctions et les finitions d'une étiquette normale outre ses fonctions d'identification électronique avec la plus grande discrétion compte tenu de sa minceur et sa souplesse. Le cas échéant, un film adhésif autocollant peut être disposé sur le film de compensation de manière à diriger l'évidement contre un objet à étiqueter et dissimuler ainsi la présence d'une puce.

En variante, le film de compensation est elle même une masse adhésive de tout type connu, de préférence épaisse et avec ou sans film protecteur amovible. Dans ce cas, c'est la masse adhésive elle même qui compense au moins en partie la hauteur du microcircuit.

L'étiquette peut comporter une double identification notamment par un code à barres imprimé sur la feuille 20 (figures 9 et 6) et par un code numérique correspondant stocké dans la mémoire du circuit intégré.

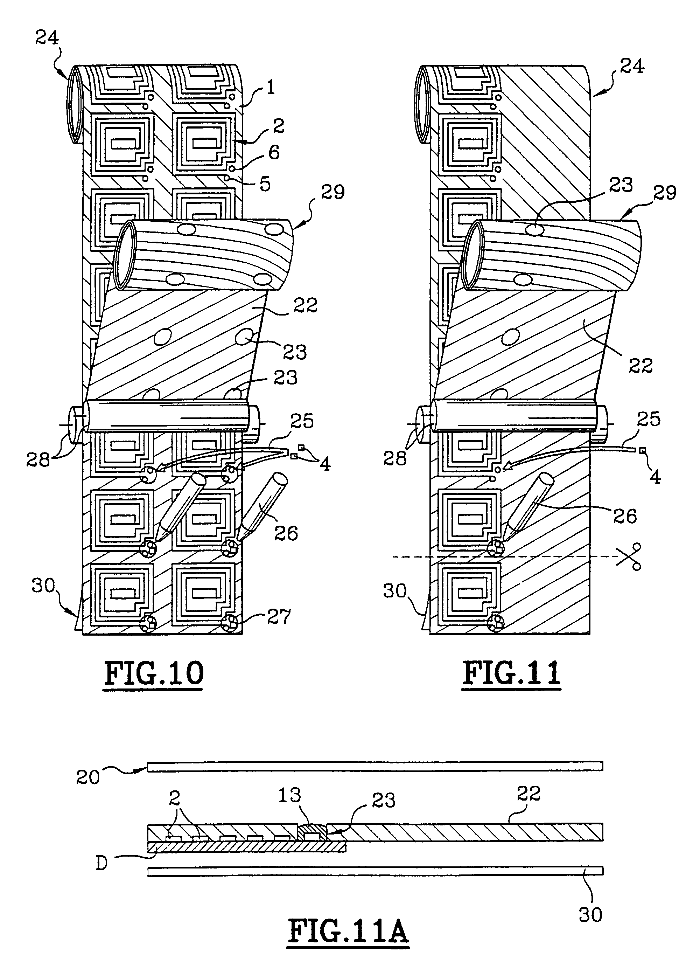

### Le procédé de fabrication des dispositifs de l'invention va maintenant être décrit en référence aux figures 10, 11 et 11A.

Selon une première étape on foumit un film support isolant 1 muni au moins d'une interface plane conductrice 2, 9. Il est appelé dans la description film support à interface.

Il peut être obtenu par une multitude de procédés connus tels que la gravure, la sérigraphie d'encre conductrice, le dépôt sélectif de matériau conducteur, la découpe d'un métal laminé et laminage sur un film support, la technique des circuits imprimés, l'incrustation de fils conducteurs sur un support isolant, etc.

Dans l'exemple, et selon une caractéristique de l'invention, on préfère recourir à un procédé de gravure de motifs imprimés ou lithographiés sur au moins un film conducteur préalablement fixé sur le film support notamment par lamination ou extrusion. On peut obtenir ainsi le cas échéant des interfaces sur chacune des faces du film support.

Le film support et l'interface sont choisis conformément aux indications données supra relatives à leurs propriétés mécaniques et leur épaisseur. Le matériau du film métallique est dans l'exemple l'aluminium préféré au cuivre en raison notamment de son prix et sa ductilité malgré des performances électriques inférieures à celles du cuivre.

Le choix de la méthode de gravure suppose le recours à une encre de masquage des pistes qui engendre une étape de retrait coûteuse après la gravure. On préfère conserver cette encre sur l'interface pour protéger l'aluminium contre l'oxydation et pour un aspect esthétique sauf localement au niveau des plots de connexion avec le microcircuit pour permettre la soudure. Le retrait local peut être effectué notamment par grattage mécanique ou laser.

En variante, on peut former l'interface avec une substance conductrice à base polymère élastique et chargée de particules métalliques telles une encre conductrice. L'élasticité de la base polymère est susceptible de satisfaire aux critères de pliage. Le dépôt peut s'effectuer par exemple par sérigraphie.

Ensuite, on fixe au moins un microcircuit sur le film support à interface, et on le connecte à l'interface.

L'ensemble des opérations est de préférence effectué à partir de bandes de film support à interface comportant une pluralité d'interfaces (motifs d'antenne par exemple) et étant fournies en rouleau ou bobines 24. Les bandes sont acheminées aux différents postes existants de fixation 25 des microcircuits 4, de connexion 26 et le cas échéant d'enrobage 27.

Comme le film support est particulièrement fin, fragile ou étirable, il n'est pas possible d'utiliser des moyens d'entraînement à picots qui engrène sur des perforations latérales des films. On utilise des moyens d'acheminement adaptés aux propriétés du film. En particulier, on utilise des moyens d'acheminement asservis à une tension du film support et qui comprennent des moyens de mesure et/ou de réglage de la tension du film support pour éviter un endommagement par étirement. L'entraînement peut par exemple être effectué par des rouleaux d'entraînement 28 ou par pinces.

Dans l'exemple, on a représenté deux motifs d'interface suivant la largeur mais on préfère utiliser des largeurs supérieures à 80 mm avec plus de motifs pour notamment une question de résistance mécanique et de productivité.

### Fixation et connexion du microcircuit.

La fixation du microcircuit peut être effectuée par tout moyen notamment des colles bi-composants, thermoadhésives, photoactivables, etc. Dans l'exemple, on préfère utiliser une colle activable aux rayons ultraviolets en raison notamment de sa rapidité de prise, du faible niveau de température requis et d'un besoin réduit en énergie.

Pour la connexion, il existe différentes manières connues plus ou moins éprouvées et émergentes telles que soudure par fils d'or ou par fils aluminium, dépôt de colles conductrices, ou du type "Flip chip" avec le microcircuit renversé, plots vers le bas, etc. Dans ces deux derniers cas, on peut s'affranchir d'enrobage et les hauteurs de connexion sont faibles.

Conformément à une caractéristique de l'invention, on réalise la connexion du microcircuit par soudure ultrasons de fils conducteurs choisis de préférence en aluminium.

Cette technique est contre-indiquée a priori sur des films support à interface très souples et/ou mous. Dans le domaine de la carte à puce, en effet, les soudures ultrasons de fils conducteurs sont réservées à des feuilles support à interface dures et rigides à base de verre époxy, polyimides et interface en cuivre avec traitement de surface de type Ni-Au.

Dans l'état de la technique de soudure par ultrasons, on a recours à un outil à souder en forme d'une pointe d'où débouche un fil à souder. Au cours du soudage on vient presser la pointe sur les plots métalliques d'interface ou de la puce silicium reposant sur la feuille support.

Les inventeurs ont constaté que des tentatives de soudures ultrasons effectuées sur des supports à interface à base de matériaux mou tel le PE ou la PP, voire le PET (selon sa qualité) en substitution de ceux couramment utilisés et avec une épaisseur supérieure à environ 75 µm par exemple 100 µm étaient vouées à l'échec, la soudure ne se faisant pas ou étant de qualité médiocre non industrielle ou non reproductible.

Les inventeurs ont toutefois réussi à effectuer des soudures de qualité industrielle et reproductibles à la condition de s'éloigner en deçà d'un certain seuil d'épaisseur. En fait, en deçà de ce seuil, ils ont découvert que plus le matériau est mince meilleure est la soudure. Cela est vrai même avec des fils d'aluminium qui sont très difficiles à souder.

Ce seuil distinct selon les matériaux est fixé à environ 75 µm pour le PE et le PP.

Une amélioration de la reproductibilité de la soudure a été obtenue en plaquant au moins la zone du film support (zone de soudure) sur laquelle va s'effectuer la soudure, à plat sur un plan de référence fixe et dur.

Le film support est plaqué par des moyens mécaniques ou de préférence par aspiration. Dans ce dernier cas, on dispose un circuit d'aspiration dans le plan fixe autour de la zone de soudure.

Ainsi, on a pu adapter une technique de connexion courante particulièrement économique de manière à la rendre fiable dans le cas de l'invention

Un film à intercalaires (non représenté) est disposé sur le film support à interface dès qu'on lui a fixé le microcircuit de manière à pouvoir l'enrouler correctement sans endommagement des microcircuits.

### Liaison des éléments d'interface.

La connexion éléments d'interface disposés éventuellement de chaque côté du film support peuvent être connectés au travers du film support par différentes manières connues de l'état de l'art notamment par réalisation de trous métallisés, en remplissant un trou par un matériau conducteur ou par décharge électrique etc.

Toutefois. grâce à la finesse du film support de l'invention et des interfaces, et à leurs caractéristiques précitées, on réalise avantageusement ces connexions par actions mécaniques avec perforations ou déchirures locales, estampage, ou plus avantageusement par rivetage, ou ultrasons avec des d'outils de forme très spécifiques.

Cette manière de procéder est particulièrement économique dans la mesure où elle s'effectue sans apport de matière, en une étape facilement intégrable et en général en temps masqué dans le procédé de fabrication du dispositif ou du film support à interface.

### Etape d'enrobage.

Pour l'étape d'enrobage, on peut avoir le matériau d'enrobage localisé juste sur une zone d'emplacement du microcircuit ou s'étendre à toute la surface du film support. Dans le premier cas, on délivre une goutte du matériau par exemple une résine. Dans le second cas, on peut déposer le matériau par enduction, sérigraphie etc. De préférence, on le dépose par pulvérisation.

La polymérisation des colles et résines, conductrices ou non, vernis, peut se faire par un apport de chaleur (thermique), localisé ou non et/ou sans échauffement notamment par radiation à certaines longueurs d'ondes, par exemple UV, ou par un mélange de deux réactifs.

On choisit de réaliser à froid notamment à une température inférieure à 80°C et à temps de polymérisation rapide, toutes les étapes de polymérisation de colles adhésives et/ou résines mêmes destinées à d'autres fins que l'enrobage. Elles sont effectuées pour certaines sous rayonnement ultraviolet. De préférence, ces étapes sont effectuées à température ambiante.

### Etape de fixation du film de compensation.

Conformément à un autre aspect de l'invention, le procédé comporte une étape selon laquelle on fixe un film de compensation 22, représenté également à la figure 10, sur le film support à interface (1, 2). Ce film de compensation possède au moins une perforation 23 correspondant à un emplacement de microcircuit. Dans l'exemple illustré à la figure 10, on colamine une bande 22 issue d'un rouleau 29 comportant une pluralité de perforations. On utilise à cet effet de préférence des adhésifs sensibles à la pression et/ou colles non polymérisables.

Cette étape s'effectue de préférence avant la fixation du microcircuit. Il est également possible mais plus délicat de colaminer ou de fixer le film de compensation après l'opération de fixation ou de connexion ou d'enrobage du microcircuit.

Comme déjà susmentionnée, cette étape peut être effectuée en relation avec tout film support à interface mais elle prend plus d'intérêt et de signification avec le film support à interface apte à être plié comme indiqué ci-avant.

L'évidement sert avantageusement à définir un espace de protection du microcircuit au cours des étapes ultérieures d'enroulement, stockage, mais aussi à servir de coffrage à un matériau d'enrobage qui est coulé dedans à l'opération 27.

### Etapes complémentaires.

Le procédé peut comprendre également une étape supplémentaire consistant à solidariser une couche supplémentaire 30 de décoration ou de protection ou adhésive sur au moins une des deux faces de l'étiquette. Dans l'exemple, on fixe une couche adhésive 30 avec son film protecteur après le report du microcircuit.

Alternativement, on peut foumir un film support comportant déjà au moins une couche supplémentaire par exemple adhésive et protégée par membrane amovible.

### Etape de découpe et d'échenillage, refente.

Suite à l'opération de gravure, II peut subsister un cadre continu (cadre c à la figure 4) autour des dispositifs, qui a l'avantage de renforcer le film support lors des étapes du procédé. Ce cadre sera ensuite éliminé par découpe. La découpe du dispositif peut être effectuée, par exemple par emporte pièce, pour l'extraire en vrac d'une bande 24 de film support à interface.

Dans un autre cas, on préfère conserver les dispositifs maintenus sur une bande ou un rouleau. A cet effet, il convient au préalable de fixer sous la bande 24 de la figure 4, une bande adhésive deux faces avec film de protection retirable. La découpe se fait de manière à ne pas couper le film de protection. Une étape d'échenillage suit alors l'étape de découpe et il reste les dispositifs adhésifs sur le film de protection.

La bande est également découpée longitudinalement à la largeur désirée (refente).

On dispose ainsi de rouleaux comportant des étiquettes adhésives au format voulu régulièrement espacées sur le rouleau protecteur de l'adhésif. L'étiquette peut être collable sur un produit quelconque. Dans d'autres cas, on utilise des adhésifs à pouvoir collant temporaire ou adhésifs non recollages, ce qui permet de faire tout le procédé en rouleau et de délivrer en rouleau les dispositifs, cartes, tickets, étiquettes non adhésives etc..

### Réalisation de produits à grande surface contenant le dispositif.

A la figure 11, on réalise par exemple des cartes à puce conforme à l'invention. Les étapes, et les références sont identiques à celles de la figure 10 sauf que le rouleau 24 comporte un seul rang de motif d'interface 2. Le film de compensation est une feuille de plus grande dimension que le film support et comporte un seul rang de perforations. Le film 30 est toujours un film de protection et/ou de décoration ou adhésif facultatif.

On remarque que ce procédé permet d'assurer un traitement des cartes en bobine comme pour les tickets et étiquettes obtenus précédemment. Le traitement en rouleaux peut également s'étendre jusqu'au conditionnement et livraison chez l'utilisateur final.

Le film de compensation peut être de toute nature notamment en papier, en cuir, en fibres non tissées ou tissées, polymères etc. Dans l'exemple, le film de compensation est un PE d'épaisseur égale à 200 µm et qui présente une surface égale à deux fois celle du dispositif.

Après découpe, on obtient une carte à puce de la figure 11 A. Le cas échéant un film 20 équivalent au film 30 peut être disposé sur la carte de manière à masquer la perforation 23.

Pour l'obtention de la carte conforme à la figure 8, on procède de manière identique au procédé illustré à la figure 11, à la différence que le film de compensation est colaminé après les étapes de fixation et connexion avec enrobage le cas échéant. Dans ce cas, les évidements 23 ne sont pas traversants et forment ainsi des cavités 21, le film de compensation devenant le corps de carte 19 après découpe de celui-ci.

On précise que les remarques effectuées à la figure 10 restent valides pour la figure 11.

Inversement non représenté, on peut utiliser un film de compensation 29 plus étroit que le film support à interface, en particulier en bordure de ce demier.

### On donne ci-dessous des compléments relatifs à certains problèmes surmontés par les inventeurs.

L'objectif de grande portée est un problème car il incompatible avec le l'objectif de diminution de coût.

L'objectif de grande portée implique d'avoir un bon conducteur électrique comme interface, (un fil de section ronde, est meilleur conducteur qu'une feuille découpée ou gravée de section rectangulaire; le cuivre est meilleur conducteur que l'Aluminium et nettement meilleur qu'une encre ou pâte conductrice....).

Il implique également d'augmenter le nombre de spires et la surface d'antenne, ce qui impliquerait d'augmenter la surface du circuit et son encombrement.

Il implique également d'avoir des dimensions et une définition de pistes optimisées, (plus les pistes sont étroites, plus les tours d'antenne sont rapprochés, plus la taille des tours est grande, et donc le flux important.

La solution au problème de coût qui est de dégrader les propriétés des films support à interface va à l'encontre de ce qui précède.

En outre, cette solution qui conduit à retenir un film support à interface (notamment en PE ou PP et en aluminium) très souple, engendre notamment les problèmes ci-après.

Les procédés actuels ne sont pas adaptés à priori, de tels films support n'ayant jamais été utilisés dans la fabrication de modules semiconducteurs.

La souplesse du film support est à priori incompatible avec la dureté d'une puce de silicium et avec la fragilité de la puce et de ses connexions.

La souplesse et minceur des films support posent des inconvénients pour un traitement collectif sous forme de rouleaux. Par exemple, le traitement collectif implique un très bon positionnement nécessaire à l'étape de report et de protection de la puce, et plus particulièrement pour la soudure fil. De tels film support ne pouvant être munis de perforations d'entraînement, il n'y a pas de guidage mécanique possible comme pour les films 35 mm.

Le recours à des matériaux conducteurs dégradés (par exemple, l'aluminium ou cuivre sans couche surfacique spécifique en particulier du type Ni-Au) pose des problèmes de soudabilité accrus par des problèmes d'oxydation.

Les complexes PP ou PE /aluminium envisagés par les inventeurs pour servir de base à des films support à interface ont des encres d'imprimerie qui sont laissées en surface du métal et qui ne peuvent être soudées. Leur retrait est coûteux et engendre la formation d'une couche d'oxyde isolante.

L'emploi d'un film support à interface dégradé notamment en rigidité (absence de Ni) conduit à retenir des matériaux mous, ce qui engendre des problèmes de soudure décrits supra. En outre, les matériaux très souples fondent en général aux températures utilisées dans les procédés de l'art antérieur.

La solution passe idéalement par une adaptation des procédés actuels utilisant des bobines 35 mm, à des bobines de grande largeur supérieure à 80 mm.

## Revendications

1. Dispositif électronique à puce comprenant un film support à interface comportant un film support (1) et au moins d'une interface conductrice plane (2, 16) disposée directement sur ledit film support (1), ainsi qu'un microcircuit (4) connecté à ladite interface, le dispositif comprenant en outre un film de compensation de hauteur (22) disposé sur le film support (1) et sur au moins une partie de l'interface, ledit film de compensation (22) comportant un évidement (21, 23) contenant ledit microcircuit (4), ses connexions (7, 8) et un matériau d'enrobage (13) du microcircuit (4).

2. Dispositif selon la revendication 1, **caractérisé en ce que** le film support (1) et l'interface sont aptes à être froissés ou pliés ensemble selon un rayon de courbure inférieur à 2,5 mm sans détérioration, et de préférence inférieur à 1 mm.

3. Dispositif selon la revendication 1 ou 2, **caractérisé en ce que** le matériau d'enrobage (13) est coffré au moins en partie par ledit évidemment (21, 23).

4. Dispositif selon l'une des revendications précédentes, **caractérisé en ce que** le film support (1) possède une épaisseur inférieure à 75 µm et de préférence comprise entre 10 µm et 30 µm.

5. Dispositif selon l'une des revendications précédentes, **caractérisé en ce que** le film support (1) possède un allongement à la rupture supérieur à 80 %, et/ou de dureté shore inférieure à 80, et/ou une température de transition vitreuse Tg inférieure à 0°C, et/ou une température de fusion inférieure à 130°C.

6. Dispositif selon l'une des revendications 1 à 5, **caractérisé en ce que** le film support (1) peut être notamment choisi parmi le PP, PE, PET.

7. Dispositif selon l'une des revendications précédentes, **caractérisé en ce que** l'interface est en aluminium.

8. Dispositif selon l'une des revendications précédentes, **caractérisé en ce que** l'interface conductrice plane est constituée par des spires (2) d'une antenne plane (3) disposée en spirale sur le film support (1) et **en ce que** le microcircuit (4) est disposé à l'extérieur des spires (2).

9. Dispositif selon l'une des revendications précédentes, **caractérisé en ce que** le film support (1) comporte un élément d'interface dit "strap" (11) sur l'autre face pour ramener au moins une extrémité (6) de l'antenne (3) au voisinage de la puce (4).

10. Dispositif selon l'une des revendications précédentes, **caractérisé en ce que** la largeur des spires (2) au niveau du microcircuit (4) sont plus fines qu'ailleurs de manière à connecter le microcircuit (4) directement sur les extrémités (6) avec une faible longueur de fil de connexion.

11. Dispositif selon l'une des revendications précédentes, **caractérisé en ce que** le microcircuit (4) est disposé entre les spires (2) directement sur le film support (1).

12. Dispositif selon l'une des revendications précédentes, **caractérisé en ce que** le microcircuit (4) est disposé dans un angle du film support (1) et directement dessus.

13. Dispositif selon l'une des revendications précédentes, **caractérisé en ce que** l'interface comporte au moins une spire (2) d'antenne conformée de manière à pouvoir communiquer à une distance supérieure à 8 cm et de préférence supérieure à 50 cm.

14. Dispositif selon l'une des revendications précédentes, **caractérisé en ce que** l'interface comporte des plages de connexion (16).

15. Dispositif selon l'une des revendications précédentes, **caractérisé en ce qu'**il comporte un matériau d'enrobage (13) sur au moins le microcircuit (4), ses connexions et au moins une portion de l'interface.

16. Dispositif selon l'une des revendications précédentes, **caractérisé en ce qu'**il comporte au moins une couche de protection/personnalisation (20) et/ou couche adhésive (30) sur au moins une de ses faces.

17. Dispositif selon l'une des revendications précédentes, **caractérisé en ce qu'**il comporte un condensateur (16a, 17b) de résonance constitué par deux surfaces conductrices disposées de part et d'autre du film support (10).

18. Dispositif selon la revendication 17, **caractérisé en ce que** le condensateur (16a, 17b) comporte un ajustage.

19. Dispositif selon l'une des revendications précédentes, **caractérisé en ce qu'**il comporte un condensateur intégré et/ou une antenne de secours compris dans le microcircuit.

20. Dispositif selon la revendication 19, **caractérisé en ce que** microcircuit (4) est apte à être alimenté et à communiquer à proximité via l'antenne de secours en cas de défaillance du circuit antenne du film support (1).

21. Carte à puce (18) **caractérisée en ce qu'**elle comporte un corps de carte (19, 22) sur lequel est fixé le dispositif (D) selon l'une des revendications précédentes, le corps de carte ayant une surface supérieure ou égale à celle du dispositif et de préférence au moins le double.

22. Carte à puce (18), **caractérisée en ce qu'**elle comporte deux feuilles externes (18, 19, 20, 30) entre lesquelles est disposé le dispositif selon l'une des revendications 1 à 20.

23. Carte à puce (18) comprenant un corps de carte (19) comportant une cavité (21) **caractérisée en ce qu'**elle comporte le dispositif selon l'une des revendications 1 à 20, le microcircuit (4) étant disposé dans la cavité (21), le film support (1) et l'interface s'étendant hors de la cavité (21) sur la surface du corps de carte (19).

24. Procédé pour la réalisation d'un dispositif électronique à puce comprenant, un film support à interface comportant un film support (1) et au moins une interface plane déposée directement sur le film support (1) et au moins un microcircuit (4) connecté à ladite interface, ledit procédé comportant des étapes selon lesquelles on fournit au moins ledit film support (1) à interface, on fixe au moins ledit microcircuit (4) sur le film support (1) à interface, et on le connecte à l'interface, le procédé comportant une étape selon laquelle, on fixe un film de compensation de hauteur (22) sur ledit film support (1) et sur au moins une partie de l'interface, ledit film de compensation (22) ayant au moins un évidement (21, 23) correspondant à un emplacement de microcircuit (4), et une étape d'enrobage du microcircuit (4) par un matériau d'enrobage (13).

25. Procédé selon la revendication 24, **caractérisé en ce que** le film de compensation (22) est déposé avant la fixation du microcircuit (4).

26. Procédé selon l'une des revendications 24 ou 25, **caractérisé en ce que** l'on coule la matière d'enrobage (13) uniquement dans l'évidement (21, 23) du film de compensation (22).

27. Procédé selon l'une des revendications 24 ou 26, **caractérisé en ce que** le film de compensation (22) est déposé après la fixation du microcircuit (4) ou l'enrobage de celui-ci.

28. Procédé selon l'une des revendications 24 à 27, **caractérisé en ce que** le film support (1) à interface est fourni en bande sur rouleau (24) et **en ce qu'**on utilise des moyens d'acheminement asservis à la tension du film support (1) pour l'acheminer vers au moins un poste de travail (25, 26, 27).

29. Procédé selon l'une des revendications 24 à 28, **caractérisé en ce que** la connexion du microcircuit (4) est réalisée par soudure ultrasons de fil conducteurs (7, 8).

30. Procédé selon la revendication 29, **caractérisé en ce que** l'on utilise des fils conducteurs (7,8) en aluminium.

31. Procédé selon l'une des revendications 29 ou 30, **caractérisé en ce que** pour la soudure, on plaque au moins l'emplacement (zp) du microcircuit (4) sur le film support (1) sur un plan de référence fixe.

32. Procédé selon la revendication 31, **caractérisé en ce que** le film support (1) est plaqué par aspiration.

33. Procédé selon l'une des revendications 24 à 32, **caractérisé en ce qu'**on réalise l'interface sur le film support (1) selon une technique de gravure d'aluminium.

34. Procédé selon l'une des revendications 24 à 33, **caractérisé en ce que** les éléments d'interface et plots de contact (5,6) sont connectés au travers du film support (1) par des perforations/déchirures mécaniques.

35. Procédé selon l'une des revendications 24 à 34, **caractérisé en ce qu'**il comporte en outre une étape selon laquelle on dépose un matériau d'enrobage (13) au moins sur le microcircuit (4) et ses connexions (7, 8).

36. Procédé selon l'une des revendications 24 à 35, **caractérisé en ce que** le matériau d'enrobage (13) est coulé dans l'évidement (23) formé par une perforation du film de compensation (22).

37. Procédé selon l'une des revendications 24 à 36, **caractérisé en ce qu'**il comporte au moins une étape supplémentaire consistant à solidariser une couche adhésive (30) avec un film de protection retirable sur au moins une face de l'étiquette.

38. Procédé selon l'une des revendications 28 à 37, **caractérisé en ce que** la bande comporte une pluralité d'interfaces et **en ce qu'**il comporte une étape consistant à découper chaque dispositif.

39. Procédé selon les revendications 37 et 38, **caractérisé en ce que** ladite couche adhésive (30) munie du film de protection est fournie en bande continue, **en ce que** les dispositifs sont découpés en restant fixés sur le film de protection et **en ce que** l'on effectue un échenillage entre les dispositifs.

## Patentansprüche

1. Elektronische Vorrichtung mit Chip, bestehend aus einer Trägerschicht mit Schnittstelle, die eine Trägerschicht (1) und mindestens eine unmittelbar auf der Trägerschicht (1) angeordnete flache Leiterschnittstelle (2, 16) aufweist, sowie einer mit der Schnittstelle verbundene Mikroschaltung (4), wobei die Vorrichtung weiterhin eine auf der Trägerschicht (1) und mindestens einem Teil der Schnittstelle aufgebrachte Höhenausgleichsschicht (22) aufweist, und wobei die Ausgleichsschicht (22) eine Vertiefung (21, 23) aufweist, in welcher sich die Mikroschaltung (4), deren Anschlüßen (7, 8) und ein Einbettungsmaterial (13) der Mikroschaltung (4) untergebracht sind.

2. Vorrichtung nach Anspruch 1, **dadurch gekennzeichnet, dass** die Trägerschicht (1) und die Schnittstelle zusammen mit einem Biegeradius von unter 2,5 mm, und bevorzugt von unter 1 mm ohne Schaden geknittert oder gebogen werden können.

3. Vorrichtung nach dem Anspruch 1 oder 2, **dadurch gekennzeichnet, dass** die Vertiefung (21, 23) zumindest teilweise das Einbettungsmaterial (13) begrenzt.

4. Vorrichtung nach einem der vorstehenden Ansprüche, **dadurch gekennzeichnet, dass** die Trägerschicht (1) eine Dicke von weniger als 75 µm, und bevorzugt von zwischen 10 µm und 30 µm hat.

5. Vorrichtung nach einem der vorstehenden Ansprüche, **dadurch gekennzeichnet, dass** die Trägerschicht (1) eine Bruchdehnung von über 80% und/oder eine Shorehärte von unter 80 und/oder eine Glasübergangstemperatur Tg von unter 0°C und/oder eine Schmelztemperatur von unter 130°C hat.

6. Vorrichtung nach einem der Ansprüche 1 bis 5, **dadurch gekennzeichnet, dass** die Trägerschicht (1) insbesondere aus einem der Materialien PP, PE und PET bestehen kann.

7. Vorrichtung nach einem der vorstehenden Ansprüche, **dadurch gekennzeichnet, dass** die Schnittstelle aus Aluminium besteht.

8. Vorrichtung nach einem der vorstehenden Ansprüche, **dadurch gekennzeichnet, dass** die flache Leiterschnittstelle aus auf der Trägerschicht (1) spiralenförmig angeordneten Windungen (2) einer flachen Antenne (3) gebildet ist, und dass die Mikroschaltung (4) außerhalb der Windungen (2) angeordnet ist.

9. Vorrichtung nach einem der vorstehenden Ansprüche, **dadurch gekennzeichnet dass** die Trägerschicht (1) ein sogenanntes "Strap"-Schnittstellenelement (11) auf der anderen Seite aufweist, um mindestens ein Endabschnitt (6) der Antenne (3) in Nähe des Chips (4) zu führen.

10. Vorrichtung nach einem der vorstehenden Ansprüche, **dadurch gekennzeichnet, dass** die Breite der Windungen (2) im Bereich der Mikroschaltung (4) kleiner ist als in den anderen Bereichen, so dass die Mikroschaltung (4) unmittelbar über einen kurzen Verbindungsdraht mit den Endabschnitten (6) verbunden werden kann.

11. Vorrichtung nach einem der vorstehenden Ansprüche, **dadurch gekennzeichnet, dass** die Mikroschaltung (4) unmittelbar auf der Trägerschicht zwischen den Windungen (2) angeordnet wird.

12. Vorrichtung nach einem der vorstehenden Ansprüche, **dadurch gekennzeichnet, dass** die Mikroschaltung (4) in einer Ecke der Trägerschicht (1) und unmittelbar darüber angeordnet ist.

13. Vorrichtung nach einem der vorstehenden Ansprüche, **dadurch gekennzeichnet, dass** die Schnittstelle mindestens eine Windung (2) einer Antenne aufweist, welche so ausgebildet ist, dass sie über eine Entfernung von mehr als 8 cm und bevorzugt von mehr als 50 cm übertragen kann.

14. Vorrichtung nach einem der vorstehenden Ansprüche, **dadurch gekennzeichnet, dass** die Schnittstelle Bond-Anschlussfelder (16) aufweist.

15. Vorrichtung nach einem der vorstehenden Ansprüche, **dadurch gekennzeichnet, dass** sie ein Einbettungsmaterial (13) auf mindestens der Mikroschaltung (4), deren Anschlüßen und mindestens einem Teil der Schnittstelle aufweist.

16. Vorrichtung nach einem der vorstehenden Ansprüche, **dadurch gekennzeichnet, dass** sie mindestens eine Schutz/Personalisierungsschicht (20) und/oder Klebeschicht (30) auf mindestens einer ihrer Seiten aufweist.

17. Vorrichtung nach einem der vorstehenden Ansprüche, **dadurch gekennzeichnet, dass** sie einen Resonanz-Kondensator (16a, 17b) aufweist, bestend aus zwei leitenden Oberflächen, die auf beiden Seiten der Trägerschicht (10) angeordnet sind.

18. Vorrichtung nach Anspruch 17, **dadurch gekennzeichnet, dass** der Kondensator (16a, 17 b) mit Passung ausgebildet ist.

19. Vorrichtung nach einem der vorstehenden Ansprüche, **dadurch gekennzeichnet, dass** sie einen integrierten Kondensator und/oder eine in der Mikroschaltung eingebaute Notantenne aufweist.

20. Vorrichtung nach Anspruch 19, **dadurch gekennzeichnet, dass** die Mikroschaltung (4) mit einer Spannung versorgt werden kann und über eine Notantenne in kurzer Entfernung übertragen kann, wenn die Antennenschaltung der Trägerschicht (1) ausfällt.

21. Chipkarte (18), **dadurch gekennzeichnet, dass** sie einen die Vorrichtung (D) nach einem der vorstehenden Ansprüche tragenden Kartenkörper (19, 22) aufweist, wobei der Kartenkörper eine Oberfläche größer oder mindestens gleich der Oberfläche der Vorrichtung besitzt und dessen Oberfläche bevorzugt doppelt so groß wie letztere ist.

22. Chipkarte (18), **dadurch gekennzeichnet, dass** sie zwei externe Folien (18, 19, 20, 30) aufweist, zwischen denen die Vorrichtung nach einem der Ansprüche 1 bis 20 angeordnet ist.

23. Chipkarte (18) bestehend aus einem Kartenkörper (19) mit einer Aushöhlung (21), **dadurch gekennzeichnet, dass** sie die Vorrichtung nach einem der Ansprüche 1 bis 20 aufweist, wobei die Mikroschaltung (4) in der Aushöhlung (21) eingesetzt ist, und die Trägerschicht (1) und die Schnittstelle sich über die Aushöhlung (21) hinaus über die Oberfläche des Kartenkörpers erstrecken (19).

24. Verfahren zur Herstellung einer elektronischen Vorrichtung mit Chip, bestehend aus einer Trägerschicht mit Schnittstelle, die eine Trägerschicht (1) und mindestens eine unmittelbar auf der Trägerschicht (1) angeordnete flache Schnittstelle und mindestens eine mit der Schnittstelle verbundene Mikroschaltung (4) aufweist, wobei das Verfahren Schritte umfasst, in denen mindestens die Trägerschicht (1) mit Schnittstelle bereitgestellt wird, mindestens die Mikroschaltung (4) auf der Trägerschicht (1) mit Schnittstelle befestigt und mit der Schnittstelle verbunden wird, wobei das Verfahren einen Schritt umfasst, in dem eine Höhenausgleichsschicht (22) auf die Trägerschicht (1) und mindestens auf einem Teil der Schnittstelle aufgebracht wird, wobei die Ausgleichsschicht (22) mindestens eine dem Platzbedarf der Mikroschaltung (4) entsprechende Vertiefung (21, 23) aufweist, und das Verfahren einen Schritt zum Einbetten der Mikroschaltung (4) mittels eines Einbettungsmaterials (13) umfasst.

25. Verfahren nach Anspruch 24, **dadurch gekennzeichnet, dass** die Ausgleichsschicht (22) vor der Befestigung der Mikroschaltung (4) aufgebracht wird.

26. Verfahren nach einem der Ansprüche 24 oder 25, **dadurch gekennzeichnet, dass** ein Einbettungsmaterial (13) lediglich in die Vertiefung (21, 23) der Ausgleichsschicht (22) gegossen wird.

27. Verfahren nach einem der Ansprüche 24 oder 26, **dadurch gekennzeichnet, dass** die Ausgleichsschicht (22) nach der Befestigung der Mikroschaltung (4) oder der Einbettung der Mikroschaltung aufgebracht wird.

28. Verfahren nach einem der Ansprüche 24 bis 27, **dadurch gekennzeichnet, dass** die Trägerschicht (1) mit Schnittstelle bandförmig auf einer Rolle (24) bereitgestellt wird und dass von der Spannung der Trägerschicht (1) abhängige Zuführungsmittel eingesetzt werden, um diese zu mindestens einer Bearbeitungsstation (25, 26, 27) zu fördern.

29. Verfahren nach einem der Ansprüche 24 bis 28, **dadurch gekennzeichnet, dass** der Anschluß der Mikroschaltung (4) durch Ultraschall-Lötung der Leiterdrähte (7, 8) hergestellt wird.

30. Verfahren nach dem Anspruch 29, **dadurch gekennzeichnet, dass** Leiterdrähte (7, 8) aus Aluminium verwendet werden.

31. Verfahren nach einem der Ansprüche 29 oder 30, **dadurch gekennzeichnet, dass** für die Lötung mindestens der Bereich (zp) der Mikroschaltung (4) auf der Trägerschicht (1) auf eine feste Referenzfläche gedrückt wird.

32. Verfahren nach dem Anspruch 31, **dadurch gekennzeichnet, dass** die Trägerschicht (1) durch Ansaugen angedrückt wird.

33. Verfahren nach einem der Ansprüche 24 bis 32, **dadurch gekennzeichnet, dass** die Schnittstelle auf der Trägerschicht (1) mittels einer Aluminium-Gravurtechnik hergestellt wird.

34. Verfahren nach einem der Ansprüche 24 bis 33, **dadurch gekennzeichnet, dass** die Schnittstellenelemente und Kontaktstifte (5, 6) durch die Trägerschicht (1) hindurch über mechanische Perforationen oder Risse verbunden sind.

35. Verfahren entsprechen einem der Ansprüche 24 bis 34, **dadurch gekennzeichnet, dass** es weiterhin einen Schritt umfasst, in dem ein Einbettungsmaterial (13) mindestens auf der Mikroschaltung (4) und deren Anschlüßen (7, 8) aufgebracht wird.

36. Verfahren nach einem der Ansprüche 24 bis 35, **dadurch gekennzeichnet, dass** das Einbettungsmaterial (13) in die Vertiefung (23) gegossen wird, welche durch eine Perforation der Ausgleichsschicht (22) gebildet wird.

37. Verfahren nach einem der Ansprüche 24 bis 36, **dadurch gekennzeichnet, dass** es mindestens einen zusätzlichen Schritt umfasst, in dem eine Klebeschicht (30) mit einer ablösbaren Schutzschicht auf mindestens einer Seite des Etikettes fest angebracht wird.

38. Verfahren nach einem der Ansprüche 28 bis 37, **dadurch gekennzeichnet, dass** das Band eine Vielzahl an Schnittstellen aufweist und dass es einen zusätzlichen Schritt zur Ausstanzung der jeweiligen Vorrichtungen umfasst.

39. Verfahren nach einem der Ansprüche 37 und 38, **dadurch gekennzeichnet, dass** die Klebeschicht (30) eine Schutzschicht aufweist und auf einem unendlichen Band bereitgestellt wird, und dass die Vorrichtungen unter Verbleibung auf der Schutzschicht ausgestanzt werden, und dass der verbleibende Bereich zwischen den Vorrichtungen abgeraupt wird.

## Claims

1. An electronic chip device comprising a support film with interface having a support film. (1) and at least one flat conductive interface (2, 16) disposed directly on said support film (1), and a microcircuit (4) connected to said interface, the device comprising in addition a height compensation film (22) disposed on the support film (1) and on at least part of the interface, said compensation film (22) having a recess (21, 23) containing said microcircuit (4), its connections (7, 8) and a material for encapsulating (13) the microcircuit (4).

2. A device according to Claim 1, **characterised in that** the support film (1) and the interface are capable of being creased or folded together without damage at a radius of curvature less than 2.5 mm, and preferably less than 1 mm.

3. A device according to Claim 1 or 2, **characterised in that** the encapsulation material (13) is encased at least partially by said recess (21, 23).

4. A device according to one of the preceding claims, **characterised in that** the support film (1) has a thickness less than 75 µm and preferably between 10 µm and 30 µm.

5. A device according to one of the preceding claims, **characterised in that** the support film (1) has an elongation at break greater than 80%, and/or Shore hardness less than 80, and/or a glass transition temperature Tg below 0°C, and/or a melting temperature below 130°C.

6. A device according to one of Claims 1 to 5, **characterised in that** the support film (1) can notably be chosen from amongst PP, PE and PET.

7. A device according to one of the preceding claims, **characterised in that** the interface is made of aluminium.

8. A device according to one of the preceding claims, **characterised in that** the flat conductive interface is constituted by turns (2) of a flat antenna (3) disposed in a spiral on the support film (1), and **in that** the microcircuit (4) is disposed outside the turns (2).

9. A device according to one of the preceding claims, **characterised in that** the support film (1) has a so-called strap interface element (11) on the other face in order to bring back at least one end (6) of the antenna (3) to the vicinity of the chip (4).

10. A device according to one of the preceding claims, **characterised in that** the width of the turns (2) in the region of the microcircuit (4) is thinner than elsewhere so as to connect the microcircuit (4) directly onto the ends (6) with a small length of connecting wire.

11. A device according to one of the preceding claims, **characterised in that** the microcircuit (4) is disposed between the turns (2) directly on the support film (1).

12. A device according to one of the preceding claims, **characterised in that** the microcircuit (4) is disposed in a corner of the support film (1) and directly on top.

13. A device according to one of the preceding claims, **characterised in that** the interface has at least one antenna turn (2) formed so as to be able to communicate at a distance greater than 8 cm and preferably greater than 50 cm.

14. A device according to one of the preceding claims, **characterised in that** the interface has connection areas (16).

15. A device according to one of the preceding claims, **characterised in that** it has an encapsulation material (13) over at least the microcircuit (4), its connections and at least one portion of the interface.

16. A device according to one of the preceding claims, **characterised in that** it has at least one protection/customization layer (20) and/or adhesive layer (30) on at least one of its faces.

17. A device according to one of the preceding claims, **characterised in that** it has a resonance capacitor (16a, 17b) constituted by two conductive surfaces disposed either side of the support film (10).

18. A device according to Claim 17, **characterised in that** the capacitor (16a, 17b) has an adjustment.

19. A device according to one of the preceding claims, **characterised in that** it has an integrated capacitor and/or a backup antenna included in the microcircuit.

20. A device according to Claim 19, **characterised in that** the microcircuit (4) is capable of being powered and of communicating close-in via the backup antenna in the case of failure of the antenna circuit of the support film (1).

21. A smart card (18), **characterised in that** it has a card body (19, 22) on which there is fixed the device (D) according to one of the preceding claims, the card body having a surface area greater than or equal to that of the device and preferably at least double.

22. A smart card (18), **characterised in that** it has two outer leaves (18, 19, 20, 30) between which there is disposed the device according to one of Claims 1 to 20.

23. A smart card (18) comprising a card body (19) having a cavity (21), **characterised in that** it includes the device according to one of Claims 1 to 20, the microcircuit (4) being disposed in the cavity (21), the support film (1) and the interface extending outside the cavity (21) over the surface of the card body (19).

24. A method for producing an electronic chip device comprising a support film with interface having a support film (1) and at least one flat interface deposited directly on the support film (1) and at least one microcircuit (4) connected to said interface, said method having steps according to which at least said support film (1) with interface is supplied, at least said microcircuit (4) is fixed onto the support film (1) with interface, and it is connected to the interface, the method having a step according to which a height compensation film (22) is fixed onto said support film (1) and onto at least part of the interface, said compensation film (22) having at least one recess (21, 23) corresponding to a location for a microcircuit (4), and a step of encapsulating the microcircuit (4) with a encapsulation material (13).

25. A method according to Claim 24, **characterised in that** the compensation film (22) is deposited before the fixing of the microcircuit (4).

26. A method according to either of Claims 24 or 25, **characterised in that** the encapsulation material (13) is poured only into the recess (21, 23) in the compensation film (22).

27. A method according to either of Claims 24 or 26, **characterised in that** the compensation film (22) is deposited after the fixing of the microcircuit (4) or the encapsulation thereof.

28. A method according to one of Claims 24 to 27, **characterised in that** the support film (1) with interface is supplied as a strip on a roll (24), and **in that** conveying means slaved to the tension of the support film (1) are used for conveying it to at least one workstation (25, 26, 27).

29. A method according to one of Claims 24 to 28, **characterised in that** the connection of the microcircuit (4) is implemented by ultrasonic welding of conductive wires (7, 8).

30. A method according to Claim 29, **characterised in that** conductive wires (7, 8) made of aluminium are used.

31. A method according to either of Claims 29 or 30, **characterised in that**, for welding, at least the location (zp) of the microcircuit (4) on the support film (1) is plated on a fixed reference plane.

32. A method according to Claim 31, **characterised in that** the support film (1) is vacuum plated.

33. A method according to one of Claims 24 to 32, **characterised in that** the interface is produced on the support film (1) according to an aluminium etching technique.

34. A method according to one of Claims 24 to 33, **characterised in that** the interface elements and contact pads (5, 6) are connected through the support film (1) by means of perforations/mechanical openings.

35. A method according to one of Claims 24 to 34, **characterised in that** it also has a step according to which an encapsulation material (13) is deposited on at least the microcircuit (4) and its connections (7, 8).

36. A method according to one of Claims 24 to 35, **characterised in that** the encapsulation material (13) is poured into the recess (23) formed by a perforation of the compensation film (22).

37. A method according to one of Claims 24 to 36, **characterised in that** it has at least one additional step consisting in immovably attaching an adhesive layer (30) with a removable protective film onto at least one face of the label.

38. A method according to one of Claims 28 to 37, **characterised in that** the strip has a plurality of interfaces, and **in that** it has a step consisting in cutting off each device.

39. A method according to Claims 37 and 38, **characterised in that** said adhesive layer (30) provided with the protective film is supplied as a continuous strip, **in that** the devices are cut off while remaining fixed on the protective film, and **in that** undesirable elements between the devices are removed.
